# EUROPÄISCHE PATENTSCHRIFT

(11) **EP 3 374 461 B1**
(45) Veröffentlichungstag und Bekanntmachung des Hinweises auf die Patenterteilung: **09.10.2019**
(21) Anmeldenummer: 16785491.8
(22) Anmeldetag: 25.10.2016
(51) Int. Cl.: C09J 153/00, C08F 230/08, H01L 51/52

(54) **BARRIEREKLEBEMASSE MIT POLYMEREM GETTERMATERIAL**
BARRIER ADHESIVE MASS WITH POLYMER GETTER MATERIAL
MATIÈRE ADHÉSIVE BARRIÈRE COMPRENANT UN MATÉRIAU GETTER POLYMÈRE

(30) Priorität: 09.11.2015 DE 102015222027
(43) Veröffentlichungstag der Anmeldung: 19.09.2018
(73) Patentinhaber: TESA SE, 22848 Norderstedt (DE)
(72) Erfinder: ROMPF, Julia, 20249 Hamburg (DE); SCHUH, Christian, 22767 Hamburg (DE); RECHER, Martin, 59650 Villeneuve d'Ascq (FR); CAO, Mengwei, 519085 Zhuhai City (CN)
(86) Internationale Anmeldenummer: PCT/EP2016/075645
(87) Internationale Veröffentlichungsnummer: WO 2017/080813

(56) Entgegenhaltungen:
- WO-A2-2009/148716
- DE-A1-102010 043 866
- US-A1- 2010 148 666

## Beschreibung

Die vorliegende Erfindung betrifft das technische Gebiet der Klebemassen, spezieller das Gebiet der Klebemassen zur Kapselung elektronischer Anordnungen. Insbesondere wird eine Barriereklebemasse vorgestellt, die ein polymeres Gettermaterial beinhaltet.

(Opto-)elektronische Anordnungen werden immer häufiger in kommerziellen Produkten verwendet. Derartige Anordnungen umfassen anorganische oder organische elektronische Strukturen, beispielsweise organische, metallorganische oder polymere Halbleiter oder auch Kombinationen dieser. Diese Anordnungen und Produkte sind je nach gewünschter Anwendung starr oder flexibel ausgebildet, wobei flexible Anordnungen zunehmend nachgefragt werden. Die Herstellung der Anordnungen erfolgt beispielsweise durch Druckverfahren wie Hochdruck, Tiefdruck, Siebdruck, Flachdruck oder auch so genanntes "non impact printing", etwa Thermotransferdruck, Tintenstrahldruck oder Digitaldruck. Vielfach werden auch Vakuumverfahren wie zum Beispiel Chemical Vapor Deposition (CVD), Physical Vapor Deposition (PVD), plasmaunterstützte chemische oder physikalische Depositionsverfahren (PECVD), Sputtern, (Plasma-)Ätzen oder Bedampfung verwendet, wobei die Strukturierung in der Regel durch Masken erfolgt.

Als Beispiele für bereits kommerzialisierte oder in ihrem Marktpotential interessante (opto-) elektronische Anwendungen seien hier elektrophoretische oder elektrochrome Aufbauten oder Displays, organische oder polymere Leuchtdioden (OLEDs oder PLEDs) in Anzeige- und Display-Vorrichtungen oder als Beleuchtung, Elektrolumineszenzlampen, lichtemittierende elektrochemische Zellen (LEECs), organische Solarzellen, beispielsweise Farbstoff- oder Polymersolarzellen, metallorganische Solarzellen, beispielsweise auf Basis metallorganischer Gerüste (MOFs) mit kristallinen Porphyrinbeschichtungen, anorganische Solarzellen, beispielsweise Dünnschichtsolarzellen, insbesondere auf der Basis von Silizium, Germanium, Kupfer, Indium und Selen, organische Feldeffekt-Transistoren, organische Schaltelemente, organische optische Verstärker, organische Laserdioden, organische oder anorganische Sensoren oder auch organisch oder anorganisch basierte RFID-Transponder angeführt.

Eine besondere technische Herausforderung für die Realisierung ausreichender Lebensdauer und Funktion von (opto-)elektronischen Anordnungen im Bereich der anorganischen und/oder organischen (Opto-)Elektronik, ganz besonders aber im Bereich der organischen (Opto-) Elektronik ist der Schutz der darin enthaltenen Komponenten vor Permeaten. Permeaten können eine Vielzahl von niedermolekularen organischen oder anorganischen Verbindungen sein, insbesondere Wasserdampf und Sauerstoff.

Viele (opto-)elektronische Anordnungen im Bereich der anorganischen und/oder organischen (Opto-)Elektronik, ganz besonders bei Verwendung von organischen Rohstoffen, sind sowohl gegen Wasserdampf als auch gegen Sauerstoff empfindlich, wobei für viele Anordnungen das Eindringen von Wasser oder Wasserdampf als größeres Problem eingestuft wird. Während der Lebensdauer der elektronischen Anordnung ist deshalb ein Schutz durch eine Verkapselung erforderlich, da andernfalls die Leistung über den Anwendungszeitraum nachlässt. So können sich beispielsweise durch eine Oxidation der Bestandteile von lichtemittierenden Anordnungen wie Elektrolumineszenz-Lampen (EL-Lampen) oder organischen Leuchtdioden (OLED) die Leuchtkraft, bei elektrophoretischen Displays (EP-Displays) der Kontrast oder bei Solarzellen die Effizienz innerhalb kürzester Zeit drastisch verringern.

Bei der anorganischen und/oder organischen (Opto-)Elektronik, insbesondere bei der organischen (Opto-)Elektronik, gibt es besonderen Bedarf für flexible Klebelösungen, die eine Permeationsbarriere für Permeate wie Sauerstoff und/oder Wasserdampf darstellen. Daneben gibt es eine Vielzahl von weiteren Anforderungen an derartige (opto)-elektronische Anordnungen. Die flexiblen Klebelösungen sollen daher nicht nur eine gute Haftung zwischen zwei Substraten erzielen, sondern zusätzlich Eigenschaften wie hohe Scherfestigkeit und Schälfestigkeit, chemische Beständigkeit, Alterungsbeständigkeit, hohe Transparenz, einfache Prozessierbarkeit sowie hohe Flexibilität und Biegsamkeit erfüllen.

Ein nach dem Stand der Technik gängiger Ansatz ist deshalb, die elektronische Anordnung zwischen zwei für Wasserdampf und Sauerstoff undurchlässige Substrate zu legen. Anschließend erfolgt dann eine Versiegelung an den Rändern. Für unflexible Aufbauten werden Glas- oder Metallsubstrate verwendet, die eine hohe Permeationsbarriere bieten, aber sehr anfällig für mechanische Belastungen sind. Ferner verursachen diese Substrate eine relativ große Dicke der gesamten Anordnung. Im Falle von Metallsubstraten besteht zudem keine Transparenz. Für flexible Anordnungen hingegen kommen Flächensubstrate wie transparente oder nicht transparente Folien zum Einsatz, die mehrlagig ausgeführt sein können. Hierbei können sowohl Kombinationen aus verschieden Polymeren als auch anorganische oder organische Schichten verwendet werden. Der Einsatz solcher Flächensubstrate ermöglicht einen flexiblen, äußerst dünnen Aufbau. Dabei sind für die verschiedenen Anwendungen unterschiedlichste Substrate wie zum Beispiel Folien, Gewebe, Vliese und Papiere oder Kombinationen daraus möglich.

Um eine möglichst gute Versiegelung zu erzielen, werden häufig spezielle Barriereklebemassen (auch als wasserdampfsperrende Klebemassen bezeichnet) verwendet. Eine gute Klebemasse für die Versiegelung von (opto-)elektronischen Bauteilen weist eine geringe Permeabilität gegen Sauerstoff und insbesondere gegen Wasserdampf auf, hat eine ausreichende Haftung auf der Anordnung und kann gut auf diese auffließen. Eine geringe Haftung auf der Anordnung verringert die Barrierewirkung an der Grenzfläche, wodurch ein Eintritt von Sauerstoff und Wasserdampf unabhängig von den Eigenschaften der Klebemasse ermöglicht wird. Nur wenn der Kontakt zwischen Masse und Substrat durchgängig ist, sind die Masseeigenschaften der bestimmende Faktor für die Barrierewirkung der Klebemasse.

Zur Charakterisierung der Barrierewirkung werden üblicherweise die Sauerstofftransmissionsrate OTR (Oxygen Transmission Rate) sowie die Wasserdampftransmissionsrate WVTR (Water Vapor Transmission Rate) angegeben. Die jeweilige Rate gibt dabei den flächen- und zeitbezogenen Fluss von Sauerstoff beziehungsweise Wasserdampf durch ein Substrat unter spezifischen Bedingungen von Temperatur und Partialdruck sowie gegebenenfalls weiteren Messbedingungen wie relativer Luftfeuchtigkeit an. Je geringer diese Werte sind, desto besser ist das jeweilige Material zur Kapselung geeignet. Die Angabe der Permeation basiert dabei nicht allein auf den Werten für WVTR oder OTR, sondern beinhaltet immer auch eine Angabe zur mittleren Weglänge der Permeation wie zum Beispiel die Dicke des Materials oder eine Normalisierung auf eine bestimmte Weglänge.

Die Permeabilität P ist ein Maß für die Durchlässigkeit eines Körpers für Gase und/oder Flüssigkeiten. Ein niedriger P-Wert kennzeichnet eine gute Barrierewirkung. Die Permeabilität P ist ein spezifischer Wert für ein definiertes Material und einen definierten Permeanten unter stationären Bedingungen bei bestimmter Permeationsweglänge, Partialdruck und Temperatur. Die Permeabilität P ist das Produkt aus Diffusions-Term D und Löslichkeits-Term S: P = D·S.

Die Bestimmung der Permeabilität für Wasserdampf (WVTR) erfolgt - auch im Sinne der vorliegenden Erfindung - nach ASTM F-1249. Die Haftklebemasse wird dazu mit einer Schichtdicke von 50 µm auf eine hochpermeable Polysulfon-Membran (erhältlich von der Firma Sartorius) aufgebracht, die selbst keinen Beitrag zur Permeationsbarriere liefert. Die Wasserdampfdurchlässigkeit wird bei 37,5 °C und einer relativen Feuchte von 90 % mit einem Messgerät (Mocon OX-Tran 2/21) bestimmt.

Der Löslichkeitsterm S beschreibt vorwiegend die Affinität der Barriereklebemasse zum Permeanten. Im Fall von Wasserdampf wird beispielsweise ein geringer Wert für S von hydrophoben Materialen erreicht. Der Diffusionsterm D ist ein Maß für die Beweglichkeit des Permeanten im Barrierematerial und ist direkt abhängig von Eigenschaften wie der Molekülbeweglichkeit oder dem freien Volumen. Oft werden bei stark vernetzten oder hochkristallinen Materialen für D relativ niedrige Werte erreicht. Hochkristalline Materialien sind jedoch in der Regel weniger transparent und eine stärkere Vernetzung führt zu einer geringeren Flexibilität. Die Permeabilität P steigt üblicherweise mit einer Erhöhung der molekularen Beweglichkeit an, etwa auch wenn die Temperatur erhöht oder der Glasübergangspunkt überschritten wird.

Ansätze, um die Barrierewirkung einer Klebemasse zu erhöhen, müssen die beiden Parameter D und S insbesondere im Hinblick auf die Durchlässigkeit von Wasserdampf und Sauerstoff berücksichtigen. Zusätzlich zu diesen chemischen Eigenschaften müssen auch Auswirkungen physikalischer Einflüsse auf die Permeabilität bedacht werden, insbesondere die mittlere Permeationsweglänge und Grenzflächeneigenschaften (Auffließverhalten der Klebemasse, Haftung). Die ideale Barriereklebemasse weist geringe D-Werte und S-Werte bei sehr guter Haftung auf dem Substrat auf.

Ein geringer Löslichkeits-Term S allein ist meist unzureichend, um gute Barriereeigenschaften zu erreichen. Ein klassisches Beispiel dafür sind insbesondere Siloxan-Elastomere. Die Materialien sind äußerst hydrophob (kleiner Löslichkeits-Term), weisen aber durch ihre frei drehbare Si-O-Bindung (großer Diffusions-Term) eine vergleichsweise geringe Barrierewirkung gegen Wasserdampf und Sauerstoff auf. Für eine gute Barrierewirkung ist also eine gute Balance zwischen Löslichkeits-Term S und Diffusions-Term D notwendig.

Hierfür wurden bisher vor allem Flüssigklebstoffe und Adhäsive auf Basis von Epoxiden verwendet (WO 98/21287 A1; US 4,051,195 A; US 4,552,604 A). Diese haben durch eine starke Vernetzung einen geringen Diffusionsterm D. Ihr Haupteinsatzgebiet sind Randverklebungen starrer Anordnungen, aber auch mäßig flexible Anordnungen. Eine Aushärtung erfolgt thermisch oder mittels UV-Strahlung. Eine vollflächige Verklebung ist aufgrund des durch die Aushärtung auftretenden Schrumpfes kaum möglich, da es beim Aushärten zu Spannungen zwischen Kleber und Substrat kommt, die wiederum zur Delaminierung führen können.

Der Einsatz dieser flüssigen Klebstoffe birgt eine Reihe von Nachteilen. So können niedermolekulare Bestandteile (VOCs - volatile organic compounds) die empfindlichen elektronischen Strukturen der Anordnung schädigen und den Umgang in der Produktion erschweren. Der Klebstoff muss aufwändig auf jeden einzelnen Bestandteil der Anordnung aufgebracht werden. Die Anschaffung von teuren Dispensern und Fixiereinrichtungen ist notwendig, um eine genaue Positionierung zu gewährleisten. Die Art der Auftragung verhindert zudem einen schnellen kontinuierlichen Prozess und auch durch den anschließend erforderlichen Laminationsschritt kann durch die geringe Viskosität das Erreichen einer definierten Schichtdicke und Verklebungsbreite in engen Grenzen erschwert sein.

Des Weiteren weisen solche hochvernetzten Klebstoffe nach dem Aushärten nur noch eine geringe Flexibilität auf. Der Einsatz von thermisch vernetzenden Systemen wird im niedrigen Temperaturbereich oder bei 2-Komponenten-Systemen durch die Topfzeit begrenzt, also die Verarbeitungszeit, bis eine Vergelung stattgefunden hat. Im hohen Temperaturbereich und insbesondere bei langen Reaktionszeiten begrenzen wiederum die empfindlichen (opto-)elektronischen Strukturen die Verwendbarkeit derartiger Systeme - die maximal anwendbaren Temperaturen bei (opto-)elektronischen Strukturen liegen manchmal nur bei 60°C, da bereits ab dieser Temperatur eine Vorschädigung eintreten kann. Insbesondere flexible Anordnungen, die organische Elektronik enthalten und mit transparenten Polymerfolien oder Verbunden aus Polymerfolien und anorganischen Schichten gekapselt sind, setzen hier enge Grenzen. Dies gilt auch für Laminierschritte unter großem Druck. Um eine verbesserte Haltbarkeit zu erreichen, sind hier eine Laminierung unter geringerem Druck und ein Verzicht auf einen temperaturbelastenden Schritt von Vorteil.

Alternativ zu den thermisch härtbaren Flüssigklebstoffen werden mittlerweile vielfach auch strahlenhärtende Klebstoffe eingesetzt (US 2004/0225025 A1). Die Verwendung von strahlenhärtenden Klebstoffen vermeidet eine lange andauernde Wärmebelastung der elektronischen Anordnung. Jedoch kommt es durch die Bestrahlung zu einer kurzfristigen punktuellen Erhitzung der Anordnung, da neben einer UV-Strahlung in der Regel auch ein sehr hoher Anteil an IR-Strahlung emittiert wird. Weitere oben genannte Nachteile von Flüssigklebstoffen wie VOC-Gehalt, Schrumpf, Delamination und geringe Flexibilität bleiben ebenfalls erhalten. Probleme können durch zusätzliche flüchtige Bestandteile oder Spaltprodukte aus den Photoinitiatoren oder Sensitizern entstehen. Zudem muss die Anordnung durchlässig für UV-Licht sein.

Da Bestandteile insbesondere organischer Elektronik und viele der eingesetzten Polymere häufig empfindlich gegen UV-Belastung sind, ist ein länger andauernder Außeneinsatz nicht ohne weitere zusätzliche Schutzmaßnahmen, etwa weitere Deckfolien, möglich. Diese können bei UV-härtenden Klebesystemen erst nach der UV-Härtung aufgebracht werden, was die Komplexität der Fertigung und die Dicke der Anordnung zusätzlich erhöht.

Die US 2006/0100299 A1 offenbart ein UV-härtbares Haftklebeband zur Kapselung einer elektronischen Anordnung. Das Haftklebeband umfasst eine Klebemasse auf Basis einer Kombination eines Polymers mit einem Erweichungspunkt von größer 60°C, eines polymerisierbaren Epoxidharzes mit einem Erweichungspunkt von unter 30°C und eines Photoinitiators. Bei den Polymeren kann es sich um Polyurethan, Polyisobutylen, Polyacrylnitril, Polyvinylidenchlorid, Poly(meth)acrylat oder Polyester, insbesondere aber um ein Acrylat handeln. Des Weiteren sind Klebharze, Weichmacher oder Füllstoffe enthalten.

Acrylatmassen haben eine sehr gute Beständigkeit gegenüber UV-Strahlung und verschiedenen Chemikalien, besitzen aber sehr unterschiedliche Klebkräfte auf verschiedenen Untergründen. Während die Klebkraft auf polaren Untergründen wie Glas oder Metall sehr hoch ist, ist die Klebkraft auf unpolaren Untergründen wie beispielsweise Polyethylen oder Polypropylen eher gering. Hier besteht die Gefahr der Diffusion an der Grenzfläche in besonderem Maße. Zudem sind diese Massen sehr polar, was eine Diffusion insbesondere von Wasserdampf, trotz nachträglicher Vernetzung, begünstigt. Durch den Einsatz polymerisierbarer Epoxidharze wird diese Tendenz weiter verstärkt.

Haftklebebänder benötigen in der Regel durch die relativ hochmolekularen Polymere im Gegensatz zu Flüssigklebstoffen für eine gute Benetzung und Haftung auf der Oberfläche eine gewisse Zeit, ausreichenden Druck und eine gute Balance zwischen viskosem Anteil und elastischem Anteil.

Die WO 2007/087281 A1 offenbart ein transparentes flexibles Haftklebeband auf Basis von Polyisobutylen (PIB) für elektronische Anwendungen, insbesondere OLED. Dabei werden Polyisobutylen mit einem Molekulargewicht von mehr als 500.000 g/mol und ein hydriertes cyclisches Harz verwendet. Optional ist der Einsatz eines photopolymerisierbaren Harzes und eines Photoinitiators möglich.

Klebemassen auf der Basis von Polyisobutylen weisen aufgrund ihrer geringen Polarität eine gute Barriere gegen Wasserdampf auf, haben aber selbst bei hohen Molekulargewichten eine relativ geringe Kohäsion, weshalb sie bei erhöhten Temperaturen häufig eine geringe Scherfestigkeit aufweisen. Der Anteil an niedermolekularen Bestandteilen kann nicht beliebig reduziert werden, da sonst die Haftung deutlich verringert wird und die Grenzflächenpermeation zunimmt. Bei Einsatz eines hohen Anteils an funktionellen Harzen, der aufgrund der sehr geringen Kohäsion der Masse notwendig ist, wird die Polarität der Masse wieder erhöht und damit der Löslichkeits-Term vergrößert.

Beschrieben sind weiterhin Barriereklebemassen auf der Basis von Styrolblockcopolymeren und möglichst hydrierten Harzen (siehe DE 10 2008 047 964 A1).

Durch die Bildung von zumindest zwei Domänen innerhalb des Blockcopolymers erhält man zusätzlich eine sehr gute Kohäsion bei Raumtemperatur und gleichzeitig verbesserte Barriereeigenschaften.

Eine Möglichkeit, die Barrierewirkung noch zu verbessern, ist der Einsatz von Stoffen, die mit Wasser oder Sauerstoff reagieren. In die (opto-)elektronische Anordnung eindringender Sauerstoff oder Wasserdampf wird dann an diese Stoffe chemisch oder physikalisch, bevorzugt chemisch, gebunden. Diese Stoffe werden in der Literatur als "Getter", "scavenger", "desiccants" oder "absorber" bezeichnet. Im Folgenden wird nur der Ausdruck Getter verwendet. Beschrieben als solche Getter sind in Klebemassen hauptsächlich anorganische Füllstoffe wie beispielsweise Calciumchlorid oder verschiedene Oxide. Da diese in der Klebemasse nicht löslich sind, haben sie den Nachteil, dass die Klebemasse ihre Transparenz und bei entsprechenden Füllgraden an Haftung verliert. Daher sind organische Getter oder Hybride, die in der Klebemasse löslich sind, besser geeignet, sie dürfen allerdings nicht aus der Klebmasse zur organischen Elektronik herauswandern. Diese Zusatzstoffe ändern weniger die Diffusionswerte, sondern im Wesentlichen die Durchbruchzeit, d.h. die Zeit, die Feuchtigkeit benötigt, um die Strecke durch die Klebemasse zurückzulegen und den empfindlichen elektronischen Aufbau zu erreichen. Sind die Stoffe mit Wasser beziehungsweise Sauerstoff gesättigt oder in einer chemischen Reaktion mit Wasser beziehungsweise Sauerstoff aufgebraucht, haben sie auch keine Wirkung mehr, die Diffusion ist dann nur die der Klebemasse ohne Getter. Trotzdem können diese Getter die Lebensdauer der (opto)-elektronischen Bauteile erhöhen.

Beispiele für die Verwendung von Gettern in Flüssigklebersystemen zur Verkapselung (opto-) elektronischer Aufbauten sind zum Beispiel in US 6,833,668 B1, JP 2000 311 782 A und EP 1 037 192 A2 gegeben.

Aus WO 03/065470 A1 ist zudem eine Haftklebemasse bekannt, die in einem elektronischen Aufbau als Transferklebemasse verwendet wird. Die Klebemasse enthält einen anorganischen funktionellen Füllstoff, der mit Sauerstoff oder Wasserdampf innerhalb des Aufbaus reagiert. Damit ist eine einfache Applikation eines Getters innerhalb des Aufbaus möglich. Für die Versiegelung des Aufbaus nach außen wird ein weiteres Adhäsiv mit geringer Durchlässigkeit verwendet. Eine ähnliche Haftklebemasse findet ihre Anwendung in JP 2004 296 381 A. Auch hier werden ausschließlich anorganische Getter verwendet.

Die DE 10 2010 043 866 A1 beschreibt eine Klebemasse zur Verkapselung, die silanmodifizierte Polymere enthält. Die Klebemasse weist gegenüber dem in der Schrift genannten Stand der Technik in gewissem Rahmen verbesserte Durchbruchszeiten auf. Trotzdem ist eine weitere Erhöhung der Durchbruchzeiten wünschenswert.

Aus dem Stand der Technik ist bekannt, dass Alkoxysilane als Wasserfänger eingesetzt werden können. In der EP 1 394 199 A1 dienen Alkoxysilane als Wasserfänger, Trockenmittel oder Vorvernetzungsverhinderer, mit anderen Worten als Stabilisatoren für insbesondere feuchtvernetzende Dichtmassen. Dabei kommen mit gleichem Erfolg sowohl monomere wie auch oligomere Alkoxysilane zum Einsatz.

WO 2013/096272 A1 beschreibt Glycidyloxygruppen enthaltende Oligosiloxane, die eine hohe chemische Resistenz von Zusammensetzungen, die organische Harze enthalten, bei Erhalt oder Verbesserung der Flexibilität dieser Zusammensetzungen bewirken sollen.

US 2012/0108733 A1 beschreibt Polyacrylat-basierte Klebemassen, die oligomere Silan-Haftvermittler enthalten. Die oligomeren Silan-Haftvermittler umfassen Alkoxysilyl- und optional Epoxy-Gruppen.

EP 0 733 689 A1 beschreibt eine Klebemasse auf Basis von Chloroprenkautschuk, die ein Oligomer aus Epoxygruppen enthaltenden Alkoxysilanen umfassen kann.

Es besteht ein anhaltender Bedarf an zur wirksamen Verkapselung (opto-)elektronischer Systeme geeigneten Klebemassen. Aufgabe der vorliegenden Erfindung war es daher, derartige Klebemassen zur Verfügung zu stellen, die hohe Durchbruchzeiten für Wasser aufweisen und daneben eine gute klebtechnische Performance bieten.

Der Lösung der Aufgabe liegt der Gedanke zugrunde, ein mehrfach funktionalisiertes polymeres Gettermaterial in den Formulierungen einzusetzen. Ein erster, allgemeiner Gegenstand der vorliegenden Erfindung ist eine Barriereklebemasse, die mindestens ein Elastomer und mindestens ein Reaktivharz umfasst und die dadurch gekennzeichnet ist, dass die Barriereklebemasse mindestens ein Polymer, das mindestens zwei zum Aufbau eines Polymers geeignete Funktionen sowie mindestens zwei hydrolysierbare Silylgruppen enthält, umfasst. Die erfindungsgemäßen Barriereklebemassen sind leicht zu handhaben und einfach zu applizieren, haben gute Klebeigenschaften und bewirken hohe Durchbruchzeiten insbesondere für Wasserdampf auch bei höheren Temperaturen.

Unter einer Barriereklebemasse wird grundsätzlich eine Klebemasse mit einer Wasserdampfpermeationsrate von weniger als 100 g/m²d, bevorzugt von weniger als 50 g/m²d, insbesondere von weniger als 15 g/m²d (jeweils bei 37,5 °C und 90 % relativer Feuchte) verstanden. Die erfindungsgemäße Barriereklebemasse lässt sich daher auch als "Wasser-Barriereklebemasse" oder als "Klebemasse mit Barrierewirkung gegen Wasser" bezeichnen.

Unter einem Elastomer wird ein Polymer mit gummielastischem Verhalten verstanden, das bei 20 °C wiederholt mindestens auf das Zweifache seiner Länge gedehnt werden kann und nach Aufhebung des für die Dehnung erforderlichen Zwanges sofort wieder annähernd seine Ausgangsdimensionen einnimmt. Als Elastomere können erfindungsgemäß prinzipiell alle im Bereich der Haftklebemassen üblichen Elastomere verwendet werden, wie sie zum Beispiel in dem "Handbook of Pressure Sensitive Adhesive Technology" von Donatas Satas (Satas & Associates, Warwick 1999), beschrieben sind. Die erfindungsgemäße Barriereklebemasse kann ein oder mehrere Elastomere enthalten.

Besonders bevorzugt ist das Elastomer ausgewählt aus der Gruppe bestehend aus Polyurethanen; Naturkautschuken; Synthesekautschuken, insbesondere Butyl-, iso-Butyl-, Nitril- und Butadienkautschuken; Vinylaromatenblockcopolymeren mit einem Elastomerblock aus ungesättigten oder teilweise oder vollständig hydrierten Polydienblöcken, insbesondere Polybutadien-, Polyisopren-, Poly(iso)butylenblöcken und Copolymerblöcken aus diesen; Polyolefinen; Fluorpolymeren und Silikonen.

Sofern das Elastomer Kautschuk oder Synthesekautschuk oder ein daraus erzeugter Verschnitt ist, dann kann der Naturkautschuk grundsätzlich aus allen erhältlichen Qualitäten wie zum Beispiel Crepe-, RSS-, ADS-, TSR- oder CV-Typen, je nach benötigtem Reinheits- und Viskositätsniveau, und der Synthesekautschuk oder die Synthesekautschuke aus der Gruppe der statistisch copolymerisierten Styrol-Butadien-Kautschuke (SBR), der Butadien-Kautschuke (BR), der synthetischen Polyisoprene (IR), der Butyl-Kautschuke (IIR), der halogenierten Butyl-Kautschuke (XIIR), der Acrylat-Kautschuke (ACM), der Ethylenvinylacetat-Copolymere (EVA) oder der Polyurethane und/oder deren Verschnitten gewählt werden.

Besonders bevorzugt ist das mindestens eine Elastomer der erfindungsgemäßen Barriereklebemasse aus zumindest einem olefinischen Monomer, insbesondere zu mindestens 50 Gew.-%, bezogen auf das Gesamtgewicht des Elastomers, aus mindestens einem olefinischen Monomer, oder aus Polyurethan aufgebaut. Ganz besonders bevorzugt ist das Elastomer ein Vinylaromatenblockcopolymer.

Sofern mehrere Elastomere in der erfindungsgemäßen Barriereklebemasse enthalten sind, sind diese bevorzugt alle aus zumindest einem olefinischen Monomer, insbesondere zu mindestens 50 Gew.-%, bezogen auf das Gesamtgewicht des Elastomers, aus mindestens einem olefinischen Monomer, oder aus Polyurethan aufgebaut. Besonders bevorzugt sind dann alle Elastomere der erfindungsgemäßen Barriereklebemasse Vinylaromatenblockcopolymere.

Das bzw. die Elastomer(e) ist bzw. sind in der erfindungsgemäßen Barriereklebemasse bevorzugt zu 20 bis 50 Gew.-%, stärker bevorzugt zu 25 bis 45 Gew.-%, insbesondere zu 28 bis 40 Gew.-%, jeweils bezogen auf das Gesamtgewicht der Barriereklebemasse, enthalten.

Unter einem Reaktivharz wird eine bei Raumtemperatur flüssige oder verflüssigbare Verbindung, insbesondere auch in Form eines Oligomers oder Polymers, verstanden, die für sich allein oder mit Reaktionsmitteln wie Härtern oder Beschleunigern aushärtet. Reaktivharze werden im Kontext der vorliegenden Erfindung auch als vernetzbare Komponenten bezeichnet. Grundsätzlich können alle auf dem Gebiet der Haftklebemassen oder Reaktivklebstoffe bekannten, in einer Aufbaureaktion vernetzenden und somit Makromoleküle bildenden reaktiven Konstituenten verwendet werden, wie sie zum Beispiel in "Gerd Habenicht: Kleben -Grundlagen, Technologien, Anwendungen, 6. Auflage, Springer, 2009" beschrieben sind. Dies sind beispielsweise Konstituenten wie Epoxidharze und/oder Phenol-, Kresol- oder Novolak-basierte Harze oder Konstituenten, die Polyester, Polyether, Polyurethane, Polysulfide oder (Meth)acrylatpolymere bilden.

Das mindestens eine Reaktivharz enthält bevorzugt cyclische Ethergruppen, besonders bevorzugt mindestens zwei Epoxy- oder Oxetangruppen. Diese Reaktivharze können monofunktionell, difunktionell, trifunktionell, tetrafunktionell oder höher funktionell bis zu polyfunktionell gestaltet sein, wobei sich die Funktionalität auf die cyclische Ethergruppe bezieht. Das mindestens eine Reaktivharz ist bevorzugt eine aliphatische Substanz. Ebenfalls bevorzugt eignet sich das mindestens eine Reaktivharz für die strahlenchemische und/oder thermische Vernetzung mit einer Erweichungstemperatur von kleiner 40 °C, bevorzugt von kleiner 20 °C.

Das mindestens eine Reaktivharz ist bevorzugt ausgewählt aus der Gruppe bestehend aus 3,4-Epoxycyclohexylmethyl-3',4'-epoxycyclohexancarboxylat (EEC) und Derivaten, Dicyclopendadiendioxid und Derivaten, 3-Ethyl-3-oxetanmethanol und Derivaten, Tetrahydrophthalsäurediglycidylester und Derivaten, Hexahydrophthalsäurediglycidylester und Derivaten, 1,2-Ethandiglycidylether und Derivaten, 1,3-Propandiglycidylether und Derivaten, 1,4-Butandioldiglycidylether und Derivaten, höheren 1,n-Alkandiglycidylethern und Derivaten, Bis-[(3,4-epoxycyclohexyl)methyl]-adipat und Derivaten, Vinylcyclohexyldioxid und Derivaten, 1,4-Cyclohexandimethanol-bis-(3,4-epoxycyclohexancarboxylat) und Derivaten, 4,5-Epoxytetrahydrophthalsäurediglycidylester und Derivaten, Bis-[1-ethyl(3-oxetanyl)methyl)ether und Derivaten, Pentaerythritoltetraglycidylether und Derivaten, Bisphenol-A-Digylcidylether (DGEBA), hydriertem Bisphenol-A-Diglycidylether, Bisphenol-F-Diglycidylether, hydriertem Bisphenol-F-Diglycidylether, Epoxyphenol-Novolaken, hydrierten Epoxyphenol-Novolaken, Epoxykresol-Novolaken, hydrierten Epoxykresol-Novolaken, 2-(7-Oxabicyclo;Spiro[1,3-dioxane-5,3'-[7]oxabicyclo[4.1.0]-heptan] und 1,4-Bis((2,3-epoxypropoxy)methyl)cyclohexan, jeweils in monomerer, dimerer, trimerer usw. bis hin zu oligomerer Form. Die Reaktivharze können in ihrer monomeren oder auch dimeren, trimeren, usw. bis hin zu ihrer oligomeren Form eingesetzt werden. Gemische von Reaktivharzen untereinander, aber auch mit anderen coreaktiven Verbindungen wie Alkoholen (monofunktionell oder mehrfach funktionell) oder Vinylethern (monofunktionell oder mehrfach funktionell) sind erfindungsgemäß möglich.

Besonders bevorzugt ist das mindestens eine Reaktivharz 3,4-Epoxycyclohexylmethyl-3',4'-epoxycyclohexancarboxylat (EEC) oder Bis-[(3,4-epoxycyclohexyl)methyl]-adipat oder ein jeweiliges Di-, Tri- usw. bis Oligomeres davon. Diese Reaktivharze eignen sich besonders gut zur kationischen Härtung. Eine derartige Härtung ist gegenüber alternativen Verfahren technisch am besten beherrschbar. Zudem erhält man mit diesen Reaktivharzen besonders gute Barriereeigenschaften.

Der Anteil der Reaktivharze in der erfindungsgemäßen Barriereklebemasse beträgt bevorzugt 15 bis 80 Gew.-%, insbesondere 20 bis 70 Gew.-% und besonders bevorzugt 25 bis 65 Gew.-%, jeweils bezogen auf das Gesamtgewicht der Barriereklebemasse. Besonders bevorzugt ist auch ein Reaktivharzanteil von 15 bis 35 Gew.-%, insbesondere von 20 bis 30 Gew.-%. Mit einem derartigen Gewichtsanteil der Reaktivharze lässt sich eine besonders gute Handhabbarkeit und Elastizität der Klebemasse nach Aushärtung erzielen. Für stärker vernetzte Verklebungen sind Reaktivharzanteile von 65 bis 80 Gew.-% bevorzugt. Besonders ausgewogen in Bezug auf Elastizität und Vernetzungsgrad sind Reaktivharzanteile von 35 bis 65 Gew.-%, jeweils bezogen auf das Gesamtgewicht der Barriereklebemasse. Auf diese Weise können Verklebungen oder Verkapselungen von elektronischen Bauteilen erhalten werden, die sowohl eine erhöhte Flexibilität als auch hervorragende Barriereeigenschaften aufweisen und somit zwei grundsätzlich einander entgegenstehende Eigenschaften miteinander kombinieren.

Der Aufbau bzw. die Struktur des mindestens einen Polymers G ist grundsätzlich unkritisch, solange das Polymer G mindestens zwei zum Aufbau eines Polymers geeignete Funktionen sowie mindestens zwei hydrolysierbare Silylgruppen enthält. Bevorzugt weist das mindestens eine Polymer G ein Poly(meth)acrylat-Rückgrat auf. Insbesondere besteht die Monomerbasis des Polymers G zu mindestens 50 Gew.-% aus Acrylsäure- und/oder Methacrylsäureestern. Das Polymer G ist somit bevorzugt ein Poly(meth)acrylat.

Unter einer "zum Aufbau eines Polymers geeigneten Funktion" wird eine Funktion verstanden, über die eine Polyreaktion verlaufen kann, d.h. eine chemische Reaktion mit gleich- oder andersartigen Funktionen, durch die aus Monomeren oder aus oligomeren Intermediaten Polymere aufgebaut werden. Es ist dabei grundsätzlich unerheblich, ob die Polyreaktion stufenlos im Sinne einer Polymerisation, d.h. nur durch Reaktion von Monomeren mit der wachsenden Polymerkette, oder stufenweise im Sinne einer Polyaddition oder Polykondensation, d.h. durch Verbindung von zunächst aus den Monomeren gebildeten Vorstufen, verläuft. Bevorzugt sind die zum Aufbau eines Polymers geeigneten Funktionen unabhängig voneinander ausgewählt aus der Gruppe bestehend aus Vinylgruppen, (Meth)acrylatgruppen, Hydroxygruppen, Aminogruppen, Isocyanatgruppen und cyclischen Ethergruppen. Die Begriffe "(Meth)acrylat" und "Poly(meth)acrylat" werden im Kontext der vorliegenden Erfindung so verstanden, dass davon sowohl Acrylsäure- als auch Methacrylsäure- basierte Verbindungen umfasst sind, die sowohl alternativ als auch gemeinsam vorhanden sein können. Besonders bevorzugt sind die zum Aufbau eines Polymers geeigneten Funktionen unabhängig voneinander ausgewählt aus (Meth)acrylatgruppen und cyclischen Ethergruppen. Ganz besonders bevorzugt sind die zum Aufbau eines Polymers geeigneten Funktionen cyclische Ethergruppen, insbesondere Epoxygruppen, beispielsweise Epoxycycloalkylgruppen.

Besonders bevorzugt weisen das mindestens eine Reaktivharz und das mindestens eine Polymer G gleichartige, insbesondere die gleichen zum Aufbau eines Polymers geeigneten Funktionen auf. In diesem Fall können Reaktivharz und Polymer G besonders gut miteinander vernetzen. Unter "gleichartigen zum Aufbau eines Polymers geeigneten Funktionen" sind dabei solche zu verstehen, die einander chemisch sehr ähnlich sind - sich beispielsweise nur hinsichtlich eines Substituenten oder der Anzahl von Ringgliedern unterscheiden - und hinsichtlich der Polymeraufbaureaktion mechanistisch in identischer Weise reagieren, z.B. cyclische Ethergruppen mit verschiedener Ringgröße oder verschiedene Acrylat- und/oder Methacrylatgruppen.
Dennoch handelt es sich bei dem Reaktivharz und dem Polymer G grundsätzlich um chemisch unterschiedliche Verbindungen. Dies bedeutet, dass Polymer G und Reaktivharz in der erfindungsgemäßen Klebemasse nicht in Gestalt einer (einzigen) Verbindung vorliegen können, die sowohl als Polymer G als auch als Reaktivharz anzusprechen wäre.

Unter einer "hydrolysierbaren Silylgruppe" wird eine Gruppierung der Form -SiR₃ verstanden, worin die Substituenten R unabhängig voneinander zunächst beliebige organische Gruppen sind, mindestens einer der Substituenten jedoch durch eine chemische Reaktion mit Wasser vom Siliziumatom abgespalten werden kann. Bevorzugt entsprechen die hydrolysierbaren Silylgruppen der Formel (I)

-Si(OR¹)ₓR²₃₋ₓ (I),

worin die Substituenten R¹ unabhängig voneinander für einen Methyl- oder Ethylrest stehen, die Substituenten R² unabhängig voneinander für einen Alkyl- oder Arylrest stehen und x = 1 bis 3 ist. Besonders bevorzugt stehen die Substituenten R¹ für einen Ethylrest. Ebenfalls besonders bevorzugt ist x = 2 oder 3. Ganz besonders bevorzugt umfassen die hydrolysierbaren Silylgruppen Triethoxysilylgruppen.

Das spezielle Substituentenmuster des bzw. der Polymere G ermöglicht vorteilhaft zum einen den Einbau der Polymere in das Netzwerk des Reaktivharzes. Zum anderen werden zum Binden von Permeaten, insbesondere von Wasser, geeignete Funktionalitäten in die Haftklebemasse eingebracht. Das Polymer G lässt sich daher auch als "Getterpolymer" bzw. "polymerer Getter" bezeichnen. Da die Polymere G in das Netzwerk des Reaktivharzes eingebaut werden, führt bei der erfindungsgemäßen Barriereklebemasse ein steigender bzw. überhaupt erst erzeugter Gehalt an Permeat, insbesondere Wasser bindenden Funktionalitäten nicht dazu, dass die Netzpunktdichte des Systems verringert wird. Im Vergleich zu monomeren und oligomeren Gettern lässt sich damit die Effizienz der Getterwirkung erheblich steigern.

Die Herstellung der Polymere G ist einerseits über Copolymerisation und andererseits über polymeranaloge Umsetzungen möglich.
Copolymerisation kann mit Monomeren A, die nach der radikalischen Polymerisation noch eine weitere reaktive Gruppe, beispielsweise cyclische Ether wie aliphatische Epoxide und Oxetane enthalten, Monomeren B, die hydrolysierbare Silylgruppen tragen, und Rückgratmonomeren C erfolgen.

Beispiele für Monomere A sind 3,4-Epoxycyclohexylmethylmethacrylat (CAS: 82428-30-6), 2,3-Epoxypropylmethacrylat (CAS: 106-91-2) und 2,3-Epoxypropylacrylat (CAS: 106-90-1).

Beispiele für Monomere B sind 3-(Triethoxysilyl)propylmethacrylat (CAS: 21142-29-0), 3-(Triethoxysilyl)propylacrylat (CAS: 20208-39-3), 3-(Trimethoxysilyl)propylacrylat (CAS: 4369-14-6), 3-(Trimethoxysilyl)propylmethacrylat (CAS: 2530-85-0), Methacryloxymethyltriethoxysilan (CAS: 5577-72-0), (Methacryloxymethyl)trimethoxysilan (CAS: 54586-78-6), (3-Acryloxypropyl)methyldimethoxysilan (CAS: 13732-00-8), (Methacryloxymethyl)methyldimethoxysilan (CAS: 121177-93-3), γ-Methacryloxypropylmethyldimethoxysilan (CAS: 3978-58-3), Methacryloxypropylmethyldiethoxysilan (CAS: 65100-04-1), 3-(dimethoxymethylsilyl)propylmethacrylat (CAS: 14513-34-9), Methyacryloxypropyldimethylethoxysilan (CAS: 13731-98-1) und Methacryloxypropyldimethylmethoxysilan (CAS: 66753-64-8).

Beispiele für Monomere C sind alle dem Fachmann bekannten radikalisch polymerisierbaren Monomere, bevorzugt Acrylate und Methacrylate.

Polymere Getter können aus Monomeren A und B sowie aus Mischungen von Monomeren A und B und zusätzlich aus Monomeren C hergestellt werden.

Die Herstellung über polymeranaloge Reaktionen kann derart erfolgen, dass zunächst Polymere mit reaktiven Seitengruppen hergestellt werden. Diese werden in einem zweiten Schritt mit Epoxiden und Alkoxysilanen funktionalisiert. Typische polymeranaloge Kopplungsreaktionen verlaufen über Isocyanate, die mit Aminen oder Alkoholen reagieren, Veresterungreaktionen, Umesterungen, Anhydride, die mit Alkoholen oder Aminen reagieren, oder nukleophile Angriffe von Alkoholen oder Aminen an Halogenatomtragenden Kohlenstoffatomen.

Bevorzugt enthält die erfindungsgemäße Barriereklebemasse insgesamt 0,5 bis 30 Gew.-%, bezogen auf das Gesamtgewicht der Klebemasse, Polymere G. Es können ein oder mehrere Polymere G enthalten sein.
In einer speziellen Ausführung enthält die erfindungsgemäße Barriereklebemasse insgesamt 0,5 bis 2 Gew.-% Polymere G. Bei diesem Gehalt ist der negative Einfluss des im Vergleich zur Klebemasse polaren polymeren Getters auf die Permeation von Wasser reduziert.
In einer weiteren speziellen Ausführung enthält die erfindungsgemäße Klebemasse insgesamt 15 bis 30 Gew.-% Polymere G. In dieser Ausführungsform hat die Klebemasse eine besonders hohe Wasseraufnahmekapazität.
In einer besonders bevorzugten Ausführung enthält die erfindungsgemäße Klebemasse insgesamt 2 bis 15 Gew.-% Polymere G. Dabei ist die Klebemasse in Bezug auf niedrige Permeation von Wasser und Wasseraufnahmekapazität besonders ausgewogen.

Die erfindungsgemäße Klebemasse umfasst darüber hinaus bevorzugt mindestens einen Initiator, besonders bevorzugt mindestens einen Initiator für eine kationische UV-Vernetzung. Insbesondere sind als Initiatoren Sulfonium-, lodonium- und Metallocenbasierte Systeme bevorzugt. Hinsichtlich Sulfonium-basierender Kationen sei auf die Ausführungen in US 6,908,722 B1 (insbesondere Spalten 10 bis 21) verwiesen.

Als Beispiele für Anionen, die als Gegenionen für die vorstehenden Kationen dienen, seien Tetrafluoroborat, Tetraphenylborat, Hexafluorophosphat, Perchlorat, Tetrachloroferrat, Hexafluoroarsenat, Hexafluoroantimonat, Pentafluorohydroxyantimonat, Hexachloroantimonat, Bi-(trifluoromethylsulfonyl)-amid und Tris-(trifluoromethylsulfonyl)-methanid genannt. Ferner sind insbesondere für Iodonium-basierende Initiatoren auch Chlorid, Bromid oder lodid als Anionen denkbar, wobei aber Initiatoren, die im Wesentlichen frei von Chlor und Brom sind, bevorzugt sind.

Konkreter zählen zu den einsetzbaren Initiatoren:
- Sulfonium-Salze wie Triphenylsulfoniumhexafluoroarsenat, Triphenylsulfoniumhexafluoroborat, Triphenylsulfoniumtetrafluoroborat, Methyldiphenylsulfoniumtetrafluoroborat, Dimethylphenylsulfoniumhexafluorophosphat, Triphenylsulfoniumhexafluorophosphat, Triphenylsulfoniumhexafluoroantimonat, Diphenylnaphthylsulfoniumhexafluoroarsenat, Tritolylsulfoniumhexafluorophosphat, Anisyldiphenylsulfoniumhexafluoroantimonat, 4-Butoxyphenyldiphenylsulfoniumtetrafluoroborat, 4-Chlorophenyldiphenylsulfoniumhexafluoroantimonat, Tris-(4-phenoxyphenyl)-sulfoniumhexafluorophosphat, Di-(4-ethoxyphenyl)-methylsulfoniumhexafluoroarsenat, 4-Acetylphenyldiphenylsulfoniumtetrafluoroborat, Tris-(4-thiomethoxyphenyl)-sulfoniumhexafluorophosphat, Di-(methoxysulfonylphenyl)-methylsulfoniumhexafluoroantimonat, Di-(methoxynaphthyl)-methylsulfoniumtetrafluoroborat, Di-(carbomethoxyphenyl)-methylsulfoniumhexafluorophosphat, (4-Octyloxyphenyl)-diphenylsulfoniumtetrakis-(3,5-bis-trifluoromethylphenyl)-borat, Tris-(dodecylphenyl)-sulfoniumtetrakis-(3,5-bis-trifluoromethylphenyl)-borat, 4-Acetamidphenyldiphenylsulfoniumtetrafluoroborat, Dimethylnaphthylsulfoniumhexafluorophosphat, Trifluoromethyldiphenylsulfoniumtetrafluoroborat, Phenylmethylbenzylsulfoniumhexafluorophosphat, 5-Methylthianthreniumhexafluorophosphat, 10-Phenyl-9,9-dimethylthioxantheniumhexafluorophosphat, 10-Phenyl-9-oxothioxantheniumtetrafluoroborat, 5-Methyl-10-oxothianthreniumtetrafluoroborat und
   5-Methyl-10,10-dioxothianthreniumhexafluorophosphat,
- lodonium-Salze wie Diphenyliodoniumtetrafluoroborat, Di-(4-methylphenyl)-iodoniumtetrafluoroborat, Phenyl-4-methylphenyliodoniumtetrafluoroborat, Di-(4-chlorphenyl)-iodoniumhexafluorophosphat, Dinaphthyliodoniumtetrafluoroborat, Di-(4-trifluormethylphenyl)-iodoniumtetrafluoroborat, Diphenyliodoniumhexafluorophosphat, Di-(4-methylphenyl)-iodoniumhexafluorophosphat, Diphenyliodoniumhexafluoroarsenat, Di-(4-phenoxyphenyl)-iodoniumtetrafluoroborat, Phenyl-2-thienyliodoniumhexafluorophosphat, 3,5-Dimethylpyrazolyl-4-phenyliodoniumhexafluorophosphat, Diphenyliodoniumhexafluoroantimonat, 2,2'-Diphenyliodoniumtetrafluoroborat, Di-(2,4-dichlorphenyl)-iodoniumhexafluorophosphat, Di-(4-bromphenyl)-iodoniumhexafluorophosphat, Di-(4-methoxyphenyl)-iodoniumhexafluorophosphat, Di-(3-carboxyphenyl)-iodoniumhexafluorophosphat, Di-(3-methoxycarbonylphenyl)-iodoniumhexafluorophosphat, Di-(3-methoxysulfonylphenyl)-iodoniumhexafluorophosphat, Di-(4-acetamidophenyl)-iodoniumhexafluorophosphat, Di-(2-benzothienyl)-iodoniumhexafluorophosphat, Diaryliodoniumtristrifluormethylsulfonylmethide wie Diphenyliodoniumhexafluoroantimonat, (4-n-Desiloxyphenyl)-phenyliodoniumhexafluoroantimonat, [4-(2-Hydroxy-n-tetradesiloxy)-phenyl]-phenyliodoniumhexafluoroantimonat, [4-(2-Hydroxy-n-tetradesiloxy)-phenyl]-phenyliodoniumtrifluorosulfonat, [4-(2-Hydroxy-n-tetradesiloxy)-phenyl]-phenyliodoniumhexafluorophosphat, Bis-(4-tert-butylphenyl)-iodoniumhexafluoroantimonat, Bis-(4-tert-butylphenyl)-iodoniumhexafluorophosphat, Bis-(4-tert-butylphenyl)-iodoniumtrifluorosulfonat, Bis-(4-tert-butylphenyl)-iodoniumtetrafluoroborat, Bis-(dodecylphenyl)-iodoniumhexafluoroantimonat, Bis-(dodecylphenyl)-iodoniumtetrafluoroborat, Bis-(dodecylphenyl)-iodoniumhexafluorophosphat, Bis-(dodecylphenyl)-iodoniumtrifluoromethylsulfonat, Di-(dodecylphenyl)-iodoniumhexafluoroantimonat, Di-(dodecylphenyl)-iodoniumtriflat, Diphenyliodoniumbisulfat, 4,4'-Dichlorodiphenyliodoniumbisulfat, 4,4'-Dibromodiphenyliodoniumbisulfat, 3,3'-Dinitrodiphenyliodoniumbisulfat, 4,4'-Dimethyldiphenyliodoniumbisulfat, 4,4'-Bis-succinimidodiphenyliodoniumbisulfat, 3-Nitrodiphenyliodoniumbisulfat, 4,4'-Dimethoxydiphenyliodoniumbisulfat und (4-Octyloxyphenyl)-phenyliodoniumtetrakis-(3,5-bis-trifluoromethylphenyl)-borat, und
- Ferrocenium-Salze wie
   η5-(2,4-cyclopentadien-1-yl)-[(1,2,3,4,5,6,9)-(1-methylethyl)-benzol]-eisen.

Es können ein oder mehrere Initiatoren enthalten sein.

Bevorzugt umfasst die erfindungsgemäße Klebemasse mindestens ein Klebharz. Besonders bevorzugt enthält die erfindungsgemäße Klebemasse mindestens ein zumindest teilhydriertes Klebharz, insbesondere eines, das mit der Elastomerkomponente beziehungsweise, sofern ein aus Hart- und Weichblöcken aufgebautes Copolymer als Elastomerkomponente eingesetzt wird, hauptsächlich mit dem Weichblock verträglich ist (Weichharz).

Bevorzugt weist das mindestens eine Klebharz eine Erweichungstemperatur, gemessen mittels Ring & Ball-Methode, von größer 25 °C auf. Besonders bevorzugt enthält die Klebemasse darüber hinaus mindestens ein Klebharz mit einer Erweichungstemperatur von kleiner 20 °C. Hierüber kann vorteilhaft zum einen das klebtechnische Verhalten, zum anderen aber auch das Auffließverhalten auf dem Verklebungsuntergrund feineingestellt werden.

Sofern das Elastomer bzw. die Elastomere der erfindungsgemäßen Barriereklebemasse eher unpolar ist bzw. sind, können als Klebharze in der erfindungsgemäßen Klebemasse vorteilhaft partiell oder vollständig hydrierte Harze auf Basis von Kolophonium und Kolophoniumderivaten, hydrierte Polymerisate des Dicyclopentadiens, partiell, selektiv oder vollständig hydrierte Kohlenwasserstoffharze auf Basis von C₅-, C₅/C₉- oder C₉-Monomerströmen, Polyterpenharze auf Basis von α-Pinen und/oder β-Pinen und/oder δ-Limonen und/oder Δ³-Caren und hydrierte Polymerisate von bevorzugt reinen C₈- und C₉-Aromaten enthalten sein. Vorgenannte Klebharze können sowohl allein als auch im Gemisch eingesetzt werden. Dabei können sowohl bei Raumtemperatur feste als auch flüssige Harze zum Einsatz kommen. Um eine hohe Alterungs- und UV-Stabilität zu gewährleisten, sind hydrierte Harze mit einem Hydrierungsgrad von mindestens 90 %, insbesondere von mindestens 95 % bevorzugt.

Die erfindungsgemäße Barriereklebemasse ist bevorzugt eine Haftklebemasse. Unter einer Haftklebemasse wird erfindungsgemäß, wie allgemein üblich, ein Stoff verstanden, der - insbesondere bei Raumtemperatur - dauerhaft klebrig sowie klebfähig ist. Charakteristisch für einen Haftklebstoff ist, dass er durch Druck auf ein Substrat aufgebracht werden kann und dort haften bleibt, wobei der aufzuwendende Druck und die Einwirkdauer dieses Drucks nicht näher definiert werden. In manchen Fällen, abhängig von der genauen Art des Haftklebstoffs, der Temperatur und der Luftfeuchtigkeit sowie des Substrats, reicht die Einwirkung eines kurzfristigen, minimalen Drucks, der über eine leichte Berührung für einen kurzen Moment nicht hinausgeht, um den Haftungseffekt zu erzielen, in anderen Fällen kann auch eine längerfristige Einwirkdauer eines hohen Drucks notwendig sein.

Haftklebstoffe haben besondere, charakteristische viskoelastische Eigenschaften, die zu der dauerhaften Klebrigkeit und Klebfähigkeit führen. Kennzeichnend für sie ist, dass, wenn sie mechanisch deformiert werden, es sowohl zu viskosen Fließprozessen als auch zum Aufbau elastischer Rückstellkräfte kommt. Beide Prozesse stehen hinsichtlich ihres jeweiligen Anteils in einem bestimmten Verhältnis zueinander, abhängig sowohl von der genauen Zusammensetzung, der Struktur und dem Vernetzungsgrad des Haftklebstoffes als auch von der Geschwindigkeit und Dauer der Deformation sowie von der Temperatur.

Der anteilige viskose Fluss ist zur Erzielung von Adhäsion notwendig. Nur die viskosen Anteile, hervorgerufen durch Makromoleküle mit relativ großer Beweglichkeit, ermöglichen eine gute Benetzung und ein gutes Anfließen auf das zu verklebende Substrat. Ein hoher Anteil an viskosem Fluss führt zu einer hohen Haftklebrigkeit (auch als Tack oder Oberflächenklebrigkeit bezeichnet) und damit oft auch zu einer hohen Klebkraft. Stark vernetzte Systeme, kristalline oder glasartig erstarrte Polymere sind mangels fließfähiger Anteile in der Regel nicht oder zumindest nur wenig haftklebrig.

Die anteiligen elastischen Rückstellkräfte sind zur Erzielung von Kohäsion notwendig. Sie werden zum Beispiel durch sehr langkettige und stark verknäuelte sowie durch physikalisch oder chemisch vernetzte Makromoleküle hervorgerufen und ermöglichen die Übertragung der auf eine Klebverbindung angreifenden Kräfte. Sie führen dazu, dass eine Klebverbindung einer auf sie einwirkenden Dauerbelastung, zum Beispiel in Form einer dauerhaften Scherbelastung, in ausreichendem Maße über einen längeren Zeitraum standhalten kann.

Zur genaueren Beschreibung und Quantifizierung des Maßes an elastischem und viskosem Anteil sowie des Verhältnisses der Anteile zueinander können die mittels Dynamisch Mechanischer Analyse (DMA) ermittelbaren Größen Speichermodul (G') und Verlustmodul (G") herangezogen werden. G' ist ein Maß für den elastischen Anteil, G" ein Maß für den viskosen Anteil eines Stoffes. Beide Größen sind abhängig von der Deformationsfrequenz und der Temperatur.

Die Größen können mit Hilfe eines Rheometers ermittelt werden. Das zu untersuchende Material wird dabei zum Beispiel in einer Platte-Platte-Anordnung einer sinusförmig oszillierenden Scherbeanspruchung ausgesetzt. Bei schubspannungsgesteuerten Geräten werden die Deformation als Funktion der Zeit und der zeitliche Versatz dieser Deformation gegenüber dem Einbringen der Schubspannung gemessen. Dieser zeitliche Versatz wird als Phasenwinkel δ bezeichnet.
Der Speichermodul G' ist wie folgt definiert: G' = (T/γ) •cos(δ) (T = Schubspannung, γ = Deformation, δ = Phasenwinkel = Phasenverschiebung zwischen Schubspannungs- und Deformationsvektor). Die Definition des Verlustmoduls G" lautet: G" = (T/γ) •sin(δ) (T = Schubspannung, γ = Deformation, δ = Phasenwinkel = Phasenverschiebung zwischen Schubspannungs- und Deformationsvektor).

Ein Stoff gilt im Allgemeinen als haftklebrig und wird im Sinne der Erfindung als haftklebrig definiert, wenn bei Raumtemperatur, hier definitionsgemäß bei 23°C, im Deformationsfrequenzbereich von 10⁰ bis 10¹ rad/sec G' zumindest zum Teil im Bereich von 10³ bis 10⁷ Pa liegt und wenn G" ebenfalls zumindest zum Teil in diesem Bereich liegt. "Zum Teil" heißt, dass zumindest ein Abschnitt der G'-Kurve innerhalb des Fensters liegt, das durch den Deformationsfrequenzbereich von einschließlich 10° bis einschließlich 10¹ rad/sec (Abszisse) sowie den Bereich der G'-Werte von einschließlich 10³ bis einschließlich 10⁷ Pa (Ordinate) aufgespannt wird. Für G" gilt dies entsprechend.

Ein weiterer Gegenstand der Erfindung ist ein Klebeband, das eine erfindungsgemäße Barriere-Haftklebemasse umfasst. Der allgemeine Ausdruck "Klebeband" umfasst dabei ein Trägermaterial, welches ein- oder beidseitig mit einer Haftklebemasse versehen ist. Das Trägermaterial umfasst alle flächigen Gebilde, beispielsweise in zwei Dimensionen ausgedehnte Folien oder Folienabschnitte, Bänder mit ausgedehnter Länge und begrenzter Breite, Bandabschnitte, Stanzlinge (beispielsweise in Form von Umrandungen oder Begrenzungen einer (opto-)elektronischen Anordnung), Mehrschichtanordnungen und dergleichen. Dabei sind für verschiedene Anwendungen unterschiedlichste Träger wie zum Beispiel Folien, Gewebe, Vliese und Papiere mit den Klebmassen kombinierbar.

Des Weiteren umfasst der Ausdruck "Klebeband" auch so genannte "Transferklebebänder", das heißt Klebebänder ohne Träger. Bei einem Transferklebeband ist die Klebemasse vielmehr vor der Applikation zwischen flexiblen Linern aufgebracht, die mit einer Trennschicht versehen sind und/oder anti-adhäsive Eigenschaften aufweisen. Zur Applikation wird regelmäßig zunächst ein Liner entfernt, die Klebemasse appliziert und dann der zweite Liner entfernt. Die Klebemasse kann so direkt zur Verbindung zweier Oberflächen in (opto-) elektronischen Anordnungen verwendet werden.
Es sind aber auch Klebebänder möglich, bei denen nicht mit zwei Linern, sondern mit einem einzigen doppelseitig trennend ausgerüsteten Liner gearbeitet wird. Die Klebebandbahn ist dann an ihrer Oberseite mit der einen Seite eines doppelseitig trennend ausgerüsteten Liners abgedeckt und an ihrer Unterseite mit der Rückseite des doppelseitig trennend ausgerüsteten Liners, wo sie insbesondere an eine benachbarte Windung auf einem Ballen oder einer Rolle angrenzt.

Das Trägermaterial des erfindungsgemäßen Klebebandes ist bevorzugt eine Polymerfolie, ein Folienverbund oder ein(e) mit organischen und/oder anorganischen Schichten versehene(r) Folie oder Folienverbund. Derartige Folien/Folienverbunde können aus allen gängigen zur Folienherstellung verwendeten Kunststoffen bestehen, beispielhaft erwähnt seien:
Polyethylen, Polypropylen - insbesondere das durch mono-oder biaxiale Streckung erzeugte orientierte Polypropylen (OPP), cyclische Olefin-Copolymere (COC), Polyvinylchlorid (PVC), Polyester - insbesondere Polyethylenterephthalat (PET) und Poylethylennaphtalat (PEN), Ethylenvinylalkohol (EVOH), Polyvinylidenchlorid (PVDC), Polyvinylidenfluorid (PVDF), Polyacrylnitril (PAN), Polycarbonat (PC), Polyamid (PA), Polyethersulfon (PES) oder Polyimid (PI).

Bei doppelseitig klebenden Klebebändern können als obere und untere Schicht erfindungsgemäße Klebemassen gleicher oder verschiedener Art und/oder gleicher oder verschiedener Schichtdicke zur Anwendung kommen. Der Träger kann dabei auf einer oder beiden Seiten dem Stand der Technik entsprechend vorbehandelt sein, so dass beispielsweise eine Verbesserung der Klebemassenverankerung erzielt wird. Ebenso können eine oder beide Seiten mit einer funktionalen Schicht ausgerüstet sein, die beispielsweise als Sperrschicht fungieren kann. Die Haftklebemasseschichten können optional mit Trennpapieren oder Trennfolien eingedeckt werden. Alternativ kann auch nur eine Klebemasseschicht mit einem doppelseitig trennenden Liner eingedeckt sein.
In einer Variante ist in dem doppelseitig klebenden Klebeband eine erfindungsgemäße Klebemasse vorgesehen sowie eine beliebige weitere, zum Beispiel eine solche, die besonders gut auf einem Abdecksubstrat haftet oder eine besonders gute Repositionierbarkeit zeigt.

Die Dicke der Haftklebemasse, die entweder als Transferklebeband oder auf einem flächigen Gebilde beschichtet vorliegt, beträgt bevorzugt zwischen 1 µm und 2000 µm, weiter bevorzugt zwischen 5 µm und 500 µm und besonders bevorzugt zwischen 12 µm und 250 µm.
Schichtdicken zwischen 50 µm und 150 µm werden bevorzugt dann eingesetzt, wenn eine verbesserte Haftung auf dem Substrat und/oder eine dämpfende Wirkung erreicht werden soll.
Schichtdicken zwischen 1 µm und 50 µm reduzieren den Materialeinsatz. Jedoch kommt es zu einer Verringerung der Haftung auf dem Substrat.

Für doppelseitige Klebebänder gilt für die Klebemasse(n) ebenfalls, dass die Dicke der einzelnen Haftklebemasseschicht(en) bevorzugt 1 µm und 2000 µm, weiter bevorzugt zwischen 5 µm und 500 µm und besonders bevorzugt zwischen 12 µm und 250 µm liegt. Kommt in doppelseitigen Klebebändern neben der einen erfindungsgemäßen Klebemasse eine weitere zum Einsatz, dann kann es auch vorteilhaft sein, wenn ihre Dicke oberhalb von 150 µm liegt.

Ein weiterer Gegenstand der Erfindung ist die Verwendung einer erfindungsgemäßen Barriereklebemasse zum Verkleben oder Versiegeln elektronischer, bevorzugt (opto-)elektronischer Anordnungen, insbesondere von elektrophoretischen oder elektrochromen Aufbauten oder Displays, organischen oder polymeren Leuchtdioden (OLEDs oder PLEDs) in Anzeige- und Display-Vorrichtungen oder als Beleuchtung, Elektrolumineszenzlampen, lichtemittierenden elektrochemischen Zellen (LEECs), organischen Solarzellen, beispielsweise Farbstoff- oder Polymersolarzellen, metallorganischen Solarzellen, beispielsweise auf Basis metallorganischer Gerüste (MOFs) mit kristallinen Porphyrinbeschichtungen, anorganischen Solarzellen, beispielsweise Dünnschichtsolarzellen, insbesondere auf der Basis von Silizium, Germanium, Kupfer, Indium und Selen, organischen Feldeffekt-Transistoren, organischen Schaltelementen, organischen optischen Verstärkern, organischen Laserdioden, organischen oder anorganischen Sensoren und organisch oder anorganisch basierten RFID-Transpondern.

### Beispiele

### Messmethoden

### Bestimmung der Durchbruchzeit

### Lebensdauertest

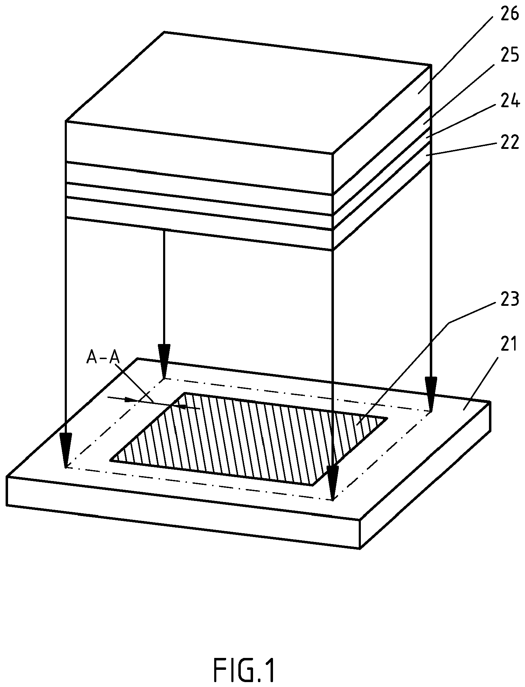

Als ein Maß für die Bestimmung der Lebensdauer eines elektronischen Aufbaus wurde ein Calciumtest herangezogen. Dieser ist in der Figur 1 gezeigt. Dazu wurde im Vakuum eine 10 x 10 mm² große, dünne Calciumschicht 23 auf eine Glasplatte 21 abgeschieden und danach unter Stickstoffatmosphäre gelagert. Die Dicke der Calciumschicht 23 lag bei etwa 100 nm. Für die Verkapselung der Calciumschicht 23 wurde ein Klebeband (23 x 23 mm²) mit der zu testenden Klebemasse 22 sowie einer Dünnglasscheibe 24 (35 µm, Firma Schott) als Trägermaterial verwendet. Zur Stabilisierung war die Dünnglasscheibe mit einer 100 µm dicken PET-Folie 26 mittels eines 50 µm dicken Transferklebebands 25 aus einer optisch hochtransparenten Acrylathaftklebemasse laminiert. Die Klebemasse 22 wurde so auf der Glasplatte 21 appliziert, dass die Klebemasse 22 den Calciumspiegel 23 mit einem allseitig überstehenden Rand von 6,5 mm (A-A) abdeckte. Aufgrund des undurchlässigen Glasträgers 24 wurde nur die Permeation durch den Haftkleber oder entlang der Grenzflächen ermittelt.

Der Test basiert auf der Reaktion von Calcium mit Wasserdampf und Sauerstoff, wie sie beispielsweise von A.G. Erlat et. al. in "47th Annual Technical Conference Proceedings-Society of Vacuum Coaters", 2004, Seiten 654 bis 659, und von M. E. Gross et al. in "46th Annual Technical Conference Proceedings-Society of Vacuum Coaters", 2003, Seiten 89 bis 92, beschrieben ist. Dabei wird die Lichttransmission der Calciumschicht überwacht, welche durch die Umwandlung in Calciumhydroxid und Calciumoxid zunimmt. Diese Umwandlung erfolgte beim beschriebenen Prüfaufbau vom Rand her, so dass sich die sichtbare Fläche des Calciumspiegels verringerte. Die Zeit bis zur Halbierung der Lichtabsorption des Calciumspiegels wird als Lebensdauer bezeichnet. Durch die Methode wurden dabei sowohl der Abbau der Fläche des Calciumspiegels vom Rand aus und durch punktuellen Abbau in der Fläche als auch die homogene Verringerung der Schichtdicke des Calciumspiegels durch vollflächigen Abbau erfasst.

Als Messbedingungen wurden 60 °C und 90 % relative Luftfeuchte gewählt. Die Muster wurden mit einer Schichtdicke der Haftklebemasse von 50 µm vollflächig und blasenfrei verklebt. Der Abbau des Ca-Spiegels wurde über Transmissionsmessungen verfolgt. Die Durchbruchzeit ist definiert als diejenige Zeit, die Feuchtigkeit benötigt, um die Strecke bis zum Ca zurückzulegen. Während dieser Zeit ändert sich die Transmission des Ca-Spiegels nur marginal.

### Klebemasseschichten

**Verwendete Rohstoffe:**

| | |
|---|---|
| Sibstar 62M | SiBS (Polystyrol-block-Polyisobutylen-Blockcopolymer, M = 60.000 g/mol) der Firma Kaneka mit 20 Gew.-% Blockpolystyrolgehalt. Die Glasübergangstemperatur der Polystyrolblöcke betrug 100 °C und die der Polyisobutylenblöcke -60 °C. Das SiBS enthielt 36 Gew.-% Zweiblockgehalt. |
| Uvacure 1500 | cycloaliphatisches Diepoxid der Firma Cytec |
| Escorez 5300 | vollhydriertes Kohlenwasserstoffharz der Firma Exxon (Ring and Ball 105 °C, DACP = 71, MMAP = 72) |
| 3-Glycidoxypropyltrimethoxysilan | Epoxy-modifiziertes Trimethoxysilan (CAS: 2530-83-8) |
| Shin-Etsu X12-981S | polymerer Getter mit Triethoxysilyl- und Epoxy-Seitengruppen, Epoxy-Äquivalent = 290 g/mol, Verhältnis (Anzahl Gruppen) Epoxy/Ethoxysilyl = 3 |
| Triarylsulfoniumhexafluoroantimonat | kationischer Fotoinitiator von der Firma Sigma-Aldrich Der Photoinitiator weist ein Absorptionsmaximum im Bereich 320 nm bis 360 nm auf und lag als 50 Gew.-%-ige Lösung in Propylencarbonat vor |

### Beispiel 1:

Zur Herstellung von Klebemasseschichten wurden verschiedene Klebemassen aus einer Lösung auf einen konventionellen Liner (silikonisierte Polyesterfolie) mittels eines Laborstreichgeräts aufgebracht und getrocknet. Die Klebemassenschichtdicke nach dem Trocknen betrug 50±5 µm. Die Trocknung erfolgte jeweils zunächst bei RT für 10 Minuten und 10 Minuten bei 120 °C in einem Labortrockenschrank. Die getrockneten Klebemasseschichten wurden jeweils unverzüglich nach dem Trocknen mit einem zweiten Liner (silikonisierte Polyesterfolie mit geringerer Trennkraft) auf der offenen Seite laminiert.

Sibstar 62M, Escorez 5300, Uvacure 1500 und der silylfunktionelle,polymere Getter (Gewichtsanteile siehe Tabelle 1) wurden in einem Gemisch aus Toluol (300 g), Aceton (150 g) und Siedegrenzenbenzin 60/95 (550 g) gelöst, so dass eine 50 Gew.-%ige Lösung entstand.
Anschließend wurde der Lösung Triarylsulfoniumhexafluoroantimonat als Photoinitiator zugesetzt.
Mittels eines Rakelverfahrens wurde die Formulierung aus Lösung auf einen silikonisierten PET-Liner beschichtet und bei 120 °C für 15 min getrocknet. Der Masseauftrag betrug 50 g/m². Das Muster wurde mit einer weiteren Lage eines ebenfalls silikonisierten, aber leichter trennenden PET-Liners eingedeckt.

Die Muster wurden in eine Glove-Box eingeschleust. Ein Teil der Muster wurde auf einem mit Ca bedampften Glassubstrat mit einem Gummianroller blasenfrei laminiert. Darauf wurde der zweite PET-Liner ausgedeckt und eine Lage eines Dünnglases auflaminiert. Anschließend wurde durch das Abdeckglas mittels UV-Licht gehärtet (Dosis: 80 mJ/cm²; Lampentyp: undotierter Quecksilberstrahler). Dieses Muster wurde für den Lebensdauertest verwendet.

**Tabelle 1: Zusammensetzungen**

| Beispiel: | K1 | K2 | K3 | K4 | V1 | V2 | V3 | V4 | V5 |
|---|---|---|---|---|---|---|---|---|---|
| | Gew.-% | Gew.-% | Gew.-% | Gew.-% | Gew.-% | Gew.-% | Gew.-% | Gew.-% | Gew.-% |
| SiBStar 62M | 35,5 | 34,7 | 33,6 | 31,7 | 37,5 | 35,5 | 34,7 | 33,6 | 31,7 |
| Uvacure 1500 | 24 | 23,5 | 22,7 | 21,5 | 25 | 24 | 23,5 | 22,7 | 21,5 |
| Shin-Etsu X12-981S | 5 | 7 | 10 | 15 | 0 | 0 | 0 | 0 | 0 |
| 3-Glycidoxypropyltrimethoxysilan | 0 | 0 | 0 | 0 | 0 | 5 | 7 | 10 | 15 |
| Escorez 5300 | 35,4 | 34,7 | 33,6 | 31,7 | 37,4 | 35,4 | 34,7 | 33,6 | 31,7 |
| Triarylsulfoniumhexafluoroantimonat | 0,1 | 0,1 | 0,1 | 0,1 | 0,1 | 0,1 | 0,1 | 0,1 | 0,1 |

Die Durchbruchzeiten von Wasser im Ca-Test sind in Tabelle 2 aufgeführt:

**Tabelle 2: Durchbruchzeiten bei Klimalagerung 60 °C / 90 % r. F.)**

| Bezeichnung | 5% Getteranteil Durchbruchzeit (h) | 7% Getteranteil Durchbruchzeit (h) | 10% Getteranteil Durchbruchzeit (h) | 15% Getteranteil Durchbruchzeit (h) |
|---|---|---|---|---|
| K1 - K4 (Getter X12-981S) | 1250 | 1400 | 1450 | 1550 |
| V2 - V5 (Getter(3-Glycidyloxypropyl) trimethoxysilan)) | 1050 | 1175 | 980 | 720 |

Die Durchbruchzeiten für Haftklebstoffe mit dem erfindungsgemäßen polymeren multifunktionellen Getter sind signifikant verbessert im Vergleich zu niedermolekularen Trimethoxysilanen (V2-V5). Dies ist insofern überraschend, als der niedermolekulare Getter eine größere Anzahl hydrolysierbarer Gruppen pro Masseeinheit enthält. Vermutlich ist dies darauf zurückzuführen, dass die zu einer Polymerisation fähigen Gruppen des erfindungsgemäßen Getters im Härtungsschritt mitreagieren und somit die Netzwerkdichte nicht wie im Fall niedermolekularer Getter reduziert wird.

## Patentansprüche

1. Barriereklebemasse, umfassend
- mindestens ein Elastomer und
- mindestens ein Reaktivharz,
**dadurch gekennzeichnet, dass**
die Barriereklebemasse mindestens ein Polymer G, enthaltend mindestens zwei zum Aufbau eines Polymers geeignete Funktionen sowie mindestens zwei hydrolysierbare Silylgruppen, umfasst.

2. Barriereklebemasse gemäß Anspruch 1, **dadurch gekennzeichnet, dass** das mindestens eine Polymer G ein Polyacrylat-Rückgrat aufweist.

3. Barriereklebemasse gemäß einem der vorstehenden Ansprüche, **dadurch gekennzeichnet, dass** die zum Aufbau eines Polymers geeigneten Funktionen unabhängig voneinander ausgewählt aus der Gruppe bestehend aus Vinylgruppen, (Meth)acrylatgruppen, Hydroxygruppen, Aminogruppen, Isocyanatgruppen, cyclischen Ethergruppen und Epoxygruppen sind.

4. Barriereklebemasse gemäß einem der vorstehenden Ansprüche, **dadurch gekennzeichnet, dass** die zum Aufbau eines Polymers geeigneten Funktionen unabhängig voneinander ausgewählt aus (Meth)acrylatgruppen und Epoxygruppen sind.

5. Barriereklebemasse gemäß einem der vorstehenden Ansprüche, **dadurch gekennzeichnet, dass** die zum Aufbau eines Polymers geeigneten Funktionen Epoxycycloalkylgruppen umfassen.

6. Barriereklebemasse gemäß einem der vorstehenden Ansprüche, **dadurch gekennzeichnet, dass** die hydrolysierbaren Silylgruppen der Formel (I) entsprechen
-Si(OR¹)ₓR²₃₋ₓ (I),
worin die Substituenten R¹ unabhängig voneinander für einen Methyl- oder Ethylrest stehen, die Substituenten R² unabhängig voneinander für einen Alkyl- oder Arylrest stehen und x = 1 bis 3 ist.

7. Barriereklebemasse gemäß Anspruch 6, **dadurch gekennzeichnet, dass** die Substituenten R¹ für einen Ethylrest stehen.

8. Barriereklebemasse gemäß einem der Ansprüche 6 und 7, **dadurch gekennzeichnet, dass** x = 2 oder 3 ist.

9. Barriereklebemasse gemäß einem der vorstehenden Ansprüche, **dadurch gekennzeichnet, dass** das mindestens eine Elastomer ein Vinylaromatenblockcopolymer ist.

10. Barriereklebemasse gemäß einem der vorstehenden Ansprüche, **dadurch gekennzeichnet, dass** das mindestens eine Reaktivharz cyclische Ethergruppen enthält.

11. Barriereklebemasse gemäß einem der vorstehenden Ansprüche, **dadurch gekennzeichnet, dass** die Klebemasse Reaktivharze zu insgesamt 15 bis 80 Gew.-%, bezogen auf das Gesamtgewicht der Barriereklebemasse, enthält.

12. Barriereklebemasse gemäß einem der vorstehenden Ansprüche, **dadurch gekennzeichnet, dass** die Barriereklebemasse eine Haftklebemasse ist.

13. Klebeband, umfassend eine Barriereklebemasse gemäß Anspruch 12.

14. Verwendung einer Barriereklebemasse gemäß einem der Ansprüche 1 bis 12 zum Versiegeln elektronischer Anordnungen.

## Claims

1. Barrier adhesive compound, comprising
- at least one elastomer and
- at least one reactive resin,
**characterized in that**
the barrier adhesive compound comprises at least one polymer G, containing at least two functional groups suitable for building a polymer and at least two hydrolyzable silyl groups.

2. Barrier adhesive compound according to Claim 1, **characterized in that** the at least one polymer G has a polyacrylate backbone.

3. Barrier adhesive compound according to either of the preceding claims, **characterized in that** the functional groups suitable for building a polymer are selected independently of one another from the group composed of vinyl groups, (meth)acrylate groups, hydroxy groups, amino groups, isocyanate groups, cyclic ether groups, and epoxy groups.

4. Barrier adhesive compound according to one of the preceding claims, **characterized in that** the functional groups suitable for building a polymer are selected independently from one another from (meth)acrylate groups and epoxy groups.

5. Barrier adhesive compound according to one of the preceding claims, **characterized in that** the functional groups suitable for building a polymer comprise epoxycycloalkyl groups.

6. Barrier adhesive compound according to one of the preceding claims, **characterized in that** the hydrolyzable silyl groups correspond to formula (I)
-Si(OR1)ₓR²₃₋ₓ (I),
wherein the substituents R¹, independently of one another, denote a methyl or ethyl residue, the substituents R², independently of one another, denote an alkyl or aryl residue, and x = 1 to 3.

7. Barrier adhesive compound according to Claim 6, **characterized in that** the substituents R¹ denote an ethyl residue.

8. Barrier adhesive compound according to either of Claims 6 and 7, **characterized in that** x = 2 or 3.

9. Barrier adhesive compound according to one of the preceding claims, **characterized in that** the at least one elastomer is a vinyl aromatic block copolymer.

10. Barrier adhesive compound according to one of the preceding claims, **characterized in that** the at least one reactive resin contains cyclic ether groups.

11. Barrier adhesive compound according to one of the preceding claims, **characterized in that** the adhesive compound contains reactive resins in a total of 15 to 80 wt.% relative to the total weight of the barrier adhesive compound.

12. Barrier adhesive compound according to one of the preceding claims, **characterized in that** the barrier adhesive compound is a pressure-sensitive adhesive compound.

13. Adhesive tape, comprising a barrier adhesive compound according to Claim 12.

14. Use of a barrier adhesive compound according to one of Claims 1 to 12 for the sealing of electronic devices.

## Revendications

1. Matière adhésive de barrière, comprenant :
- au moins un élastomère et
- au moins une résine réactive,
**caractérisée en ce que**
la matière adhésive de barrière comprend au moins un polymère G, contenant au moins deux fonctions appropriées pour la formation d'un polymère, ainsi qu'au moins deux groupes silyle hydrolysables.

2. Matière adhésive de barrière selon la revendication 1, **caractérisée en ce que** ledit au moins un polymère G présente un squelette de polyacrylate.

3. Matière adhésive de barrière selon l'une quelconque des revendications précédentes, **caractérisée en ce que** les fonctions appropriées pour la formation d'un polymère sont choisies indépendamment les unes des autres dans le groupe constitué par les groupes vinyle, les groupes (méth)acrylate, les groupes hydroxy, les groupes amino, les groupes isocyanate, les groupes éther cycliques et les groupes époxy.

4. Matière adhésive de barrière selon l'une quelconque des revendications précédentes, **caractérisée en ce que** les fonctions appropriées pour la formation d'un polymère sont choisies indépendamment les unes des autres parmi les groupes (méth)acrylate et les groupes époxy.

5. Matière adhésive de barrière selon l'une quelconque des revendications précédentes, **caractérisée en ce que** les fonctions appropriées pour la formation d'un polymère comprennent des groupes époxycycloalkyle.

6. Matière adhésive de barrière selon l'une quelconque des revendications précédentes, **caractérisée en ce que** les groupes silyle hydrolysables correspondent à la formule (I) :
-Si(OR¹)ₓR²₃₋ₓ (I)
dans laquelle les substituants R¹ représentent indépendamment les uns des autres un radical méthyle ou éthyle, les substituants R² représentent indépendamment les uns des autres un radical alkyle ou aryle, et x = 1 à 3.

7. Matière adhésive de barrière selon la revendication 6, **caractérisée en ce que** les substituants R¹ représentent un radical éthyle.

8. Matière adhésive de barrière selon l'une quelconque des revendications 6 et 7, **caractérisée en ce que** x = 2 ou 3.

9. Matière adhésive de barrière selon l'une quelconque des revendications précédentes, **caractérisée en ce que** ledit au moins un élastomère est un copolymère séquencé de composés aromatiques de vinyle.

10. Matière adhésive de barrière selon l'une quelconque des revendications précédentes, **caractérisée en ce que** ladite au moins une résine réactive contient des groupes éther cycliques.

11. Matière adhésive de barrière selon l'une quelconque des revendications précédentes, **caractérisée en ce que** la matière adhésive contient des résines réactives au total à hauteur de 15 à 80 % en poids, par rapport au poids total de la matière adhésive de barrière.

12. Matière adhésive de barrière selon l'une quelconque des revendications précédentes, **caractérisée en ce que** la matière adhésive de barrière est une matière adhésive de contact.

13. Bande adhésive, comprenant une matière adhésive de barrière selon la revendication 12.

14. Utilisation d'une matière adhésive de barrière selon l'une quelconque des revendications 1 à 12 pour le scellement de systèmes électroniques.
